# DEMANDE DE BREVET EUROPEEN

(11) **EP 3 166 132 A1**
(43) Date de publication de la demande: **10.05.2017**
(21) Numéro de dépôt: 16197394.6
(22) Date de dépôt: 04.11.2016
(51) Int. Cl.: H01L 21/18, H01L 21/20, H01L 21/762

(54) **PROCEDE DE FABRICATION DE SUBSTRATS**

(30) Priorité: 09.11.2015 FR 1560722
(71) Demandeur: COMMISSARIAT À L'ÉNERGIE ATOMIQUE ET AUX ÉNERGIES ALTERNATIVES, 75015 Paris (FR); Soitec, 38190 Bernin (FR)
(72) Inventeur: MORICEAU, Hubert, 38120 SAINT-EGREVE (FR); IMBERT, Bruno, 38000 GRENOBLE (FR); BLOT, Xavier, 38000 GRENOBLE (FR)
(74) Mandataire: Brevalex

(57) **Abrégé**

L'invention concerne un procédé de fabrication comprenant les étapes suivantes :
a) fournir un premier substrat comprenant une première face dite face avant (11), ladite face avant étant faite d'un semi-conducteur de type III-V,
b) fournir un second substrat,
c) former une couche d'oxyde radicalaire sur ladite face avant, du premier substrat par exécution d'une oxydation radicalaire,
d) assembler, par une étape de collage direct, le premier substrat et le second substrat de manière à former un assemblage comprenant la couche d'oxyde radicalaire intercalée entre les premier et second substrats,
e) exécuter un traitement thermique destinée à renforcer l'interface de l'assemblage formée à l'étape d), et à faire disparaître, au moins partiellement, la couche d'oxyde radicalaire.

## Description

### DOMAINE TECHNIQUE ET ART ANTÉRIEUR

L'invention concerne un procédé de fabrication d'un empilement comprenant un premier substrat semi-conducteur de type III-V et un second substrat, l'empilement étant destiné à être utilisé, par exemple, dans les domaines de l'énergie, de l'optoélectronique, et de la microélectronique.

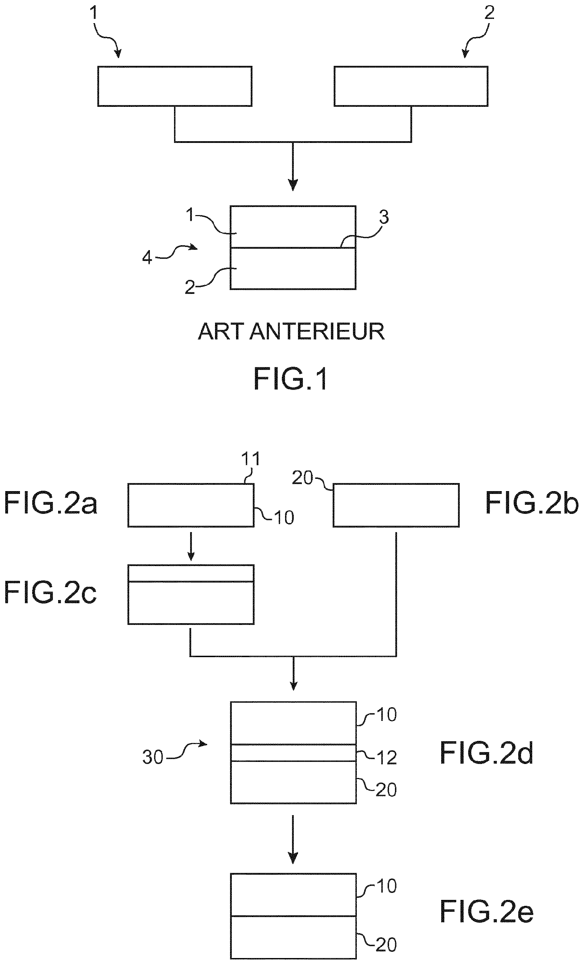

La figure 1 présente un procédé de fabrication connu de l'état de la technique et décrit par K. Nakayama et al. [1] qui comprend les étapes suivantes :
a) fournir un premier substrat 1 semi-conducteur de type III-V,
b) fournir un second substrat 2 semi-conducteur de type III-V,
c) assembler le premier substrat 1 et le second substrat 2 de manière à former un assemblage comprenant le premier substrat 1 et le second substrat 2.

Cependant ce procédé n'est pas satisfaisant.

En effet, avant d'être mises en contact à l'étape c) d'assemblage, les surfaces des premier et second substrats sont en général nettoyées de façon à être en tout ou partie désoxydées, et avoir un caractère hydrophile. L'étape c) correspond, en général, à une étape de collage direct de surfaces hydrophiles. Il y a donc une présence d'eau à l'interface d'assemblage des premier et second substrats. Cette eau favorise la génération d'un oxyde de type natif, à l'interface des substrats collés, d'autant plus facilement que les surfaces mises en contact ont été efficacement désoxydées. La génération de cet oxyde de type natif n'est pas maîtrisée et cela engendre en général des problèmes de reproductibilité du collage et des propriétés physiques et chimiques à l'interface de collage.

En outre des oxydes natifs générés avant, pendant ou après les nettoyages et avant la mise en contact sont également pénalisants car ils peuvent réagir de façon non maîtrisée avec l'eau présente à l'interface de collage.

Ainsi, des oxydes natifs peuvent être présents sur les surfaces des premier 1 et second 2 substrats semi-conducteurs de type III-V destinées à être assemblées. Ils sont difficilement reproductibles car ils dépendent fortement de nombreux paramètres environnementaux (humidité, température, nature de l'atmosphère, présence de contaminant...). La présence desdits oxydes natifs dégrade ainsi les propriétés de conductivités électrique et/ou thermique de l'interface de l'assemblage formé à l'étape c) du procédé connu de l'état de la technique.

Par ailleurs, parmi les oxydes natifs présents sur la surface d'un substrat semi-conducteur de type III-V, certains peuvent se sublimer à des températures inférieures à 200°C. Ceci est particulièrement dommageable lorsqu'un traitement thermique, qui est généralement réalisé à des températures supérieures à 200°C, doit être exécuté pour renforcer l'interface de l'assemblage ainsi formé.

En outre, la diversité d'oxydes natifs pouvant être observés sur la surface d'un substrat semi-conducteur de type III-V nuit à la maîtrise du procédé de fabrication, et peut introduire une variabilité des propriétés de l'interface d'assemblage. Il apparaît nécessaire de maîtriser toute à la fois l'eau à l'interface de collage et la présence des oxydes natifs

Il pourrait être avantageux d'effectuer un retrait des oxydes natifs avant l'exécution de l'étape c) d'assemblage.

Le retrait des oxydes natifs peut être réalisé à l'aide d'une solution chimique comprenant par exemple du fluorure d'hydrogène (HF), ou du sulfure d'ammonium (ammonium sulfide, (NH₄)₂S), solution choisie suivant le type de matériaux à désoxyder et selon les connaissances de l'homme de l'art.

Aussi, afin d'éviter, ou de ralentir, la reformation des oxydes natifs sur les surfaces, une étape de passivation desdites surfaces est alors exécutée à la suite de l'étape de retrait des oxydes. L'étape de passivation permet de saturer les surfaces désoxydées avec des atomes, par exemple des atomes d'hydrogène ou d'azote ou de soufre.

En outre l'étape de désoxydation peut être aussi l'étape de passivation.

Or, la passivation ne résiste pas longtemps dès lors que les surfaces destinées à être assemblées sont à nouveau exposées à l'atmosphère ambiante avant d'exécuter l'étape c) d'assemblage. Il s'en suit alors une reformation des oxydes natifs sur les surfaces à assembler.

Par conséquent, le délai entre l'étape de passivation et l'étape c) de collage direct doit être assez court, par exemple inférieur ou de l'ordre de l'heure, voire de l'ordre de quelques minutes, pour pouvoir bénéficier des effets de la passivation.

Par ailleurs, l'étape de passivation peut supposer l'emploi d'une solution chimique à base de (NH₄)₂S, qui est un produit coûteux et difficile à manipuler.

En outre, une étape de passivation peut introduire une contamination à l'interface d'assemblage.

Pour pallier à ces problèmes, Shiro Uchida *et al.* [2], propose qu'une étape d'activation par bombardement par faisceau d'ions, des surfaces des premier 1 et second 2 substrats destinées à être mises en contact, soit exécutée avant l'étape c) d'assemblage.

L'exposition des surfaces au bombardement par faisceau d'ions, par exemple d'argon, a pour effet de retirer les oxydes natifs, et d'activer lesdites surfaces, à savoir former des liaisons pendantes.

Cependant, ce procédé n'est, également, pas satisfaisant.

En effet, afin de ne pas réoxyder les surfaces activées, Shiro Uchida *et al.* [2] propose de pratiquer l'étape c) d'assemblage dans une chambre à vide poussé (« high vacuum chamber » selon la terminologie Anglo-Saxonne) incorporant le canon à ions argon nécessaire au bombardement par faisceau d'ions de surfaces précitée.

Un tel dispositif est à la fois coûteux, et compliqué à mettre en oeuvre. Par ailleurs, la faible cadence (« Through Put » selon la terminologie Anglo-Saxonne) de production d'un tel équipement pénalise le temps de cycle, et rend ledit équipement incompatible avec les requis d'un environnement industriel.

Cependant, l'obtention d'hétérostuctures comprenant un empilement d'un premier et d'un second substrats présentant une surface composée de matériaux semi-conducteurs de type III-V ou supportant des couches de matériaux semi-conducteurs de type III-V (par exemple, un empilement d'alliages de phosphure d'indium et d'alliages d'arséniure de gallium) présentant une faible résistance électrique et thermique à l'interface de collage est d'un grand intérêt dans les domaines de l'énergie, de l'optoélectronique et de la microélectronique.

Notamment, lors de la fabrication de cellules photovoltaïques, des substrats de phosphure d'indium 1 sur arséniure de gallium 2 sont bien adaptés pour former par croissance épitaxiale les jonctions destinées à transformer l'énergie lumineuse en énergie électrique.

De tels substrats doivent présenter une bonne résistance mécanique et/ou thermique de manière à ne pas subir de dégradations lors des étapes de fabrication des cellules photovoltaïques.

Par ailleurs, afin de pouvoir collecter le courant électrique généré par les cellules photovoltaïques, il est nécessaire d'obtenir une résistance électrique spécifique (mesurée en ohm.cm²) à l'interface de collage 3 la plus faible possible.

Un but de l'invention est donc de définir un procédé de fabrication d'un empilement comprenant un premier substrat présentant une surface composée de matériaux semi-conducteurs de type III-V et un second substrat et présentant une interface d'assemblage mieux maîtrisée.

Un autre but de l'invention est également de définir un procédé de fabrication permettant d'alléger les contraintes de temps et/ou technologiques imposées par les procédés connus de l'état de la technique.

### EXPOSÉ DE L'INVENTION

Les buts précédemment énoncés sont atteints par un procédé de fabrication comprenant les étapes suivantes :
a) fournir un premier substrat comprenant une première face dite face avant, ladite face avant étant faite d'un semi-conducteur de type III-V,
b) fournir un second substrat,
c) former une couche d'oxyde radicalaire sur ladite face avant, du premier substrat par exécution d'une étape d'oxydation radicalaire,
d) assembler, par une étape de collage direct, le premier substrat et le second substrat de manière à former un assemblage comprenant la couche d'oxyde radicalaire intercalée entre les premier et second substrats,
e) exécuter un traitement thermique destinée à renforcer l'interface de l'assemblage formée à l'étape d), et à faire disparaître, au moins partiellement, la couche d'oxyde radicalaire.

L'invention prévoit de créer volontairement, avant l'étape d), une couche d'oxyde radicalaire par voie d'oxydation radicalaire. La couche d'oxyde radicalaire est maîtrisée, reproductible et stable.

La couche d'oxyde radicalaire créée par voie radicalaire peut disparaître au moins partiellement à relativement basse température de sorte que l'interface de l'assemblage est conductrice électriquement et/ou thermiquement.

Ainsi la couche d'oxyde radicalaire formée par oxydation radicalaire sur la face avant du substrat semi-conducteur permet de passiver la surface de façon stable, à savoir rendre ladite surface chimiquement inerte à l'air libre pendant plusieurs heures. En effet, la couche d'oxyde radicalaire ralenti très fortement, voire prévient, alors la reformation d'une couche d'oxyde natif, sur la face avant du substrat semi-conducteur de type III-V. Grâce à la stabilité dans le temps de la couche d'oxyde radicalaire, un temps d'attente de plusieurs heures (par exemple entre 1 et 4 heures) peut être autorisé entre l'étape c) et l'étape d). Ainsi, contrairement à ce qui est observé dans l'état de la technique, les contraintes de temps sont relâchées.

Par ailleurs, la présence de la couche d'oxyde radicalaire limite toute réaction du substrat semi-conducteur de type III-V avec l'eau présente à l'interface d'assemblage. L'interface d'assemblage est alors mieux maîtrisée.

En outre, la Demanderesse a constaté que la couche d'oxyde radicalaire formée par oxydation radicalaire, et présente à l'interface d'assemblage à l'issue de l'étape d), disparait, au moins partiellement, sous l'effet d'un traitement thermique.

De plus, toute dégradation de la face avant, telle qu'une amorphisation sur une partie superficielle du premier substrat, par exemple sur quelques nanomètres d'épaisseur, peut être amoindrie voire supprimée par l'étape c) d'oxydation radicalaire qui consomme la partie amorphisée (dégradée) du premier substrat.

Selon un mode de mise en oeuvre, l'étape c) d'oxydation radicalaire est exécutée à pression atmosphérique.

Par pression atmosphérique, on entend une pression comprise entre 0,5 bar et 5 bar, préférentiellement entre 0,5 bar et 1,5 bar, encore plus préférentiellement entre 0,9 bar et 1,1 bar.

Selon un mode de mise en oeuvre, la face avant est désoxydée avant l'exécution de l'étape c).

Selon un mode de mise en oeuvre, l'étape d), de collage direct, est exécutée sous une atmosphère à humidité contrôlée selon une des conditions suivantes :
- sous une atmosphère présentant une pression partielle en eau inférieure à 10⁻¹ Pa,
   ou
- sous un vide partiel, le vide partiel présentant une pression inférieure à 10 Pa, préférentiellement inférieure à 1 Pa, encore plus préférentiellement inférieure à 10⁻¹ Pa.

Ainsi la quantité d'eau présente à l'interface d'assemblage à l'issue de l'étape d) de collage direct est réduite, limitant ainsi de manière plus efficace les réactions secondaires susceptibles de se produire à l'interface de collage.

Selon un mode de mise en oeuvre, l'épaisseur de la couche d'oxyde radicalaire, formée à l'étape c), est inférieure à 5 nm, préférentiellement inférieure à 3 nm, encore plus préférentiellement inférieure à 2 nm.

Selon un mode de mise en oeuvre, l'oxydation radicalaire, est exécutée sous une atmosphère d'ozone et/ou d'oxygène illuminée par un rayonnement ultraviolet.

Selon un mode de mise en oeuvre, le second substrat comprend au moins un des éléments choisis parmi : silicium, germanium, alliage de silicium/germanium, saphir, verre, quartz, SiC, alumine.

Selon un mode de mise en oeuvre, le second substrat est un substrat comprenant une seconde face, dite seconde face avant, ladite face étant faite d'un semi-conducteur de type III-V, le procédé comprend également une étape c1), de formation d'une seconde couche d'oxyde radicalaire par oxydation radicalaire, sur la seconde face avant, la seconde couche d'oxyde radicalaire étant en contact avec la couche d'oxyde radicalaire après d'étape d) de collage direct.

Selon un mode de mise en oeuvre, la seconde face avant est désoxydée avant exécution de l'étape c1).

Selon un mode de mise en oeuvre, l'épaisseur de la seconde couche d'oxyde radicalaire est inférieure à 5 nm, préférentiellement inférieure à 3 nm, encore plus préférentiellement inférieure à 2 nm.

Selon un mode de mise en oeuvre, le second substrat comprend au moins un des éléments à base de : InP, GaAs, In₁₋ₓAsₓP, InP₁₋ₓGaₓ, In₁₋ₓAsₓP_{1-y}Ga_{y}, des alliages de matériaux des colonnes III et V.

Selon un mode de mise en oeuvre, le premier substrat comprend au moins un des éléments à base de : InP, GaAs, In₁₋ₓAsₓP, InP₁₋yGa_{y}, In₁₋ₓAsₓP_{1-y}Ga_{y}, des alliages de matériaux des colonnes III et V.

### BRÈVE DESCRIPTION DES DESSINS

D'autres caractéristiques et avantages apparaîtrons dans la description qui va suivre des modes de mise en oeuvre du procédé de fabrication selon l'invention, donnés à titre d'exemples non limitatifs, en référence aux dessins annexés dans lesquels :
- la figure 1 est une représentation schématique d'un procédé de fabrication connu de l'art antérieur,
- les figures 2a - 2e sont une représentation schématique d'un premier mode de réalisation du procédé selon l'invention,
- les figures 3a - 3e sont une représentation schématique d'un second mode de réalisation de procédé selon l'invention.

### EXPOSÉ DÉTAILLÉ DE MODES DE RÉALISATION PARTICULIERS

Pour les différents modes de mise en oeuvre, les mêmes références seront utilisées pour des éléments identiques ou assurant la même fonction, par souci de simplification de la description.

Substrat monobloc : par substrat monobloc (« bulk » selon la terminologie Anglo-Saxonne), on entend un substrat présentant une composition chimique essentiellement identique en tout point de son volume.

Partie superficielle d'un substrat : par partie superficielle d'un substrat, on entend une zone du substrat s'étendant depuis une surface libre, notamment sa face avant, vers l'intérieur de celui-ci, sur une épaisseur inférieure à quelques nm, par exemple inférieure à 5 nm.

Semi-conducteur de type III-V : par semi-conducteur de type III-V, on entend un alliage comprenant un élément de la colonne III et un élément de la colonne V de la classification périodique des éléments, le semi-conducteur de type III-V étant éventuellement dopé.

Passivation de surface : par passivation de surface, on entend rendre la surface d'un substrat chimiquement inerte à son environnement extérieur.

Selon une premier mode de réalisation, le procédé de fabrication, illustré aux figures 2a - 2e, comprend une étape a) consistant à fournir un premier substrat 10.

Le premier substrat 10 comprend une première face, dite face avant 11. Ladite face avant 11 est faite d'un matériau semi-conducteur de type III-V et cristallin, avantageusement monocristallin

Par exemple le premier substrat 10 peut être monobloc.

De manière avantageuse, la rugosité de la face avant 11 est compatible avec une étape de collage direct. Par exemple, la rugosité de la face avant 11 est inférieure à 1 nm RMS, de préférence inférieure à 0,5 nm, mesurée par microscopie à force atomique (« Atomic Force Microscopy » selon la terminologie anglosaxonne), et selon un champ de mesure de 5 µm x 5 µm.

Le premier substrat 10 peut comprendre au moins un des matériaux choisi parmi : InP, GaAs, In₁₋ₓAsₓP, InP₁₋yGa_{y}, In₁₋ₓAsₓP_{1-y}Ga_{y}, des alliages de matériaux des colonnes III et V.

Le premier substrat 10 peut être composite voire inclure des niveaux de procédés. En particulier, le premier substrat 10 peut comprendre un substrat support et des couches d'intérêt, actives ou passives.

Le procédé de fabrication comprend une étape b), qui consiste à fournir un second substrat 20 cristallin, avantageusement monocristallin.

Le second substrat 20 peut comprendre au moins un des matériaux : silicium, germanium, alliage de silicium/germanium, saphir, alumine, verre, quartz, SiC.

Le premier substrat 10 peut être composite voire inclure des niveaux de procédés. En particulier, le premier substrat 10 peut comprendre un substrat support et des couches d'intérêt, actives ou passives.

Le procédé selon l'invention comprend une étape c) qui consiste à former une couche d'oxyde radicalaire 12 sur ladite face avant 11 par une étape d'oxydation radicalaire.

La couche d'oxyde radicalaire 12 est obtenue en oxydant une partie superficielle du premier substrat 10.

La partie superficielle du substrat 10 s'étend de la face avant 11 du premier substrat 10 vers l'intérieur de celui-ci

L'oxydation radicalaire n'affecte pas la rugosité de la face avant 11 du premier substrat 10, et permet donc de conserver une rugosité compatible avec une étape de collage direct.

Par ailleurs, l'étape c) d'oxydation radicalaire consomme les oxydes natifs susceptibles d'être présents sur la face avant 11 du premier substrat 10.

L'étape d'oxydation radicalaire, permettant la formation de la couche d'oxyde radicalaire 12, est réalisée par génération d'une espèce radicalaire oxydante , par exemple de l'oxygène atomique radical (noté ici O*, agent oxydant fort). L'oxygène atomique radical (radical, ou radical libre) peut être obtenu par illumination Ultraviolette, par exemple d'oxygène, et/ou d'ozone, et/ou d'eau.

L'étape c) d'oxydation radicalaire peut être exécutée à pression atmosphérique, et en évitant des traitements thermiques d'oxydation à haute température. Par pression atmosphérique, on entend une pression comprise entre 0,5 bar et 5 bar, préférentiellement entre 0,5 bar et 1,5 bar, encore plus préférentiellement entre 0,9 bar et 1,1 bar.

L'oxygène radicalaire O*, étant une espèce instable (donc très réactive), réagit avec la face avant 11 pour oxyder ladite surface.

L'étape d'oxydation radicalaire est préférentiellement assistée par un rayonnement ultraviolet qui participe à la formation de l'oxygène radicalaire.

Selon un mode de réalisation particulièrement avantageux, l'étape d'oxydation radicalaire est réalisée à partir d'oxygène, et/ou d'ozone, et/ou d'eau, et d'un rayonnement ultraviolet ayant des longueurs d'onde primaires préférentiellement de l'ordre de 185 nm et de 254 nm (par exemple rayonnement d'une lampe à vapeur de mercure basse pression).

De manière particulièrement avantageuse, l'étape d'oxydation radicalaire est réalisée avec l'oxygène environnant. Sous l'action du rayonnement ultraviolet, l'oxygène se dissocie en ozone et en oxygène radicalaire O*. L'oxygène radicalaire O* réagit alors avec la face avant 11 du premier substrat 10 pour former la couche d'oxyde radicalaire 12.

Ainsi, l'oxygène atomique est alors généré, partir d'oxygène illuminé par un rayonnement UV comprenant deux longueurs d'onde λ₁ et λ₂, selon les deux réactions de principe :

- O₂ + λ₁ → 2O* et O₂ + O* → O₃, avec λ₁ (longueur d'onde d'illumination) < 240 nm (1)

- O₃ + λ₂ → O* + O₂, avec 240 nm < λ₂ < 320 nm (2)

L'illumination UV, comprenant les deux longueurs d'onde λ₁ et λ₂, peut être exécutée à l'aide d'un équipement comprenant une lampe UV à basse pression de vapeur de mercure. En effet, le spectre d'émission UV, d'une telle lampe UV à basse pression de vapeur de mercure, comprend deux raies d'intensités notables aux longueurs d'ondes λ₁ = 184,9 nm et λ₂ = 253,7 nm. Ainsi, l'illumination de l'oxygène avec les deux longueurs d'onde λ₁ = 184,9 nm et λ₂ = 253,7 nm permet de former détruire continuellement l'ozone formé lors de la réaction (1), et donc d'avoir de l'oxygène radical en permanence.

En outre, l'étape d'oxydation radicalaire n'endommage pas la surface lors de l'oxydation. Par exemple, un substrat d'InP de rugosité (mesurée par AFM dans une gamme de fréquence spatiale > 1 µm⁻¹) inférieure à 0,5 nm en valeur RMS avant traitement (par exemple de 0,3 nm) ne sera pas affecté après traitement d'oxydation radicalaire, et présentera à une rugosité inférieure à 0.5nm RMS (0,3 nm pour l'exemple) après exécution de l'étape d'oxydation radicalaire. Par conséquent, la surface sera toujours compatible avec une étape de collage direct d) discutée ci-après.

L'oxygène atomique peut également être généré, à partir d'ozone également illuminé par un rayonnement UV.

Dans ce cas de figure, les réactions (1) et (2) restent valables. L'ozone peut être généré, quant à lui, de diverses manières et par exemple :
Il est par exemple possible de générer de l'ozone à partir d'oxygène.

Plus particulièrement, l'illumination de l'oxygène avec un rayonnement UV comprenant la longueur d'onde λ₁ = 184,9 nm, l'ozone peut être généré dans un équipement comportant une lampe émettant un rayonnement UV comprenant la longueur d'onde λ₁ = 184,9 nm, et dans lequel on laisse entrer au moins une des espèces choisie parmi : de l'oxygène, de l'air sec, de l'air humide... Ainsi, dans le cas de l'oxygène par exemple, ce dernier sous l'effet d'un rayonnement UV comprenant la longueur d'onde λ₁ = 184.9 nm se transforme en ozone selon la réaction (1) (O₂ + λ₁ → 2O* et O₂ + O* → O₃). Typiquement, des concentrations d'ozone dans l'oxygène ou dans l'air atmosphérique standard supérieures à 1g/m³ peuvent être atteintes, et par exemple de l'ordre de quelques g/m³ d'air (par ex 3 g/m³). On atteint donc, à la pression atmosphérique, des rapports de masse d'ozone sur la masse d'air typiquement compris entre 0,1% et 1 % (par exemple 0,25 %). L'équipement Jelight-UVOCs commercialisé par la société Jelight Company peut par exemple être utilisé.

L'ozone peut également être obtenu à l'aide d'un générateur d'ozone, par exemple un générateur d'ozone commercial (par exemple du type Ozone Generator BMT 803 commercialisé par la société BMT Messtechnik GMBH). La quantité d'ozone produite (en g/m³) dépend fortement du débit mesuré en slm (standard litre par minute) du gaz initial (par exemple oxygène). Typiquement, on peut atteindre des concentrations de quelques dizaines de g/m³ (par exemple 30 g/m³) à 250 g/m³, en fonction du débit de gaz à l'entrée. On atteint donc, à la pression atmosphérique, des rapports de masse d'ozone sur la masse d'air compris, typiquement, entre 1% et 25%. Il est possible d'utiliser un équipement du type SAMCO-UV2.

En outre et de manière particulièrement avantageuse, la radiation avec un rayonnement UV comprenant la longueur d'onde λ₂ = 253,7 nm est également absorbée par de nombreux hydrocarbones. L'excitation de ces hydrocarbones et la présence d'oxygène radical induit la formation d'espèces volatiles qui désorbent de la surface. Ainsi, dès lors que des hydrocarbones sont présents sur la face avant 11 du premier substrat 10, l'étape c) d'oxydation radicalaire permet de transformer lesdits hydrocarbones en espèces volatiles, et ainsi participe au nettoyage de ladite face avant 11. Cet effet est particulièrement intéressant pour l'étape de collage direct d) discutée ci-après.

Au demeurant, on peut générer de l'oxygène radical également à partir d'autres gaz. On cite par exemple le dioxyde d'azote NO₂ qui libère un oxyde nitrique NO et un radical O*.

Nous notons qu'il est également possible d'obtenir des radicaux à partir d'autres espèces contenant de l'oxygène, par exemple, des radicaux libres centrés sur l'oxygène, et parmi lesquels on peut citer HO₂* (radical perhydroxyle), HO* (radical hydroxyle), RO₂* (radical peroxyle), RO* (radical alkoxyle)...

De manière avantageuse, l'étape d'oxydation radicalaire est réalisée à une température inférieure à 400°C, avantageusement à température ambiante.

Ainsi, une oxydation radicalaire réalisée à température ambiante est plus lente de sorte que la vitesse d'oxydation radicalaire est mieux contrôlée.

Dans certaines applications, notamment lorsqu'une épaisseur plus importante de la couche d'oxyde radicalaire 12 est souhaitée, il est possible d'accélérer le processus d'oxydation radicalaire en utilisant des températures supérieures à la température ambiante. Une couche d'oxyde radicalaire 12 d'une épaisseur importante peut être souhaitable lorsque des oxydes natifs sont présents sur la face avant 11 du premier substrat 10.

En outre si pour une raison (par exemple pour oxyder une zone amorphe sur quelques nanomètres), l'oxyde radicalaire, intéressant pour sa maîtrise et sa stabilité, doit être généré avec une épaisseur supérieure à l'épaisseur visée pour l'étape de collage d), alors une étape supplémentaire d'amincissement de la couche d'oxyde radicalaire peut être mise en oeuvre. Cette étape peut être réalisée de façon très précise par une attaque chimique en voie liquide (par exemple au moyen d'une solution contenant du sulfure d'ammonium (ammonium sulfide) ou du fluorure d'hydrogène, HF) ou au moyen d'une gravure sèche (par exemple avec usage d'un gaz réducteur).

Contrairement à une oxydation thermique, l'oxydation radicalaire ne nécessite pas l'utilisation d'équipements lourds, et complexes à mettre en oeuvre.

La couche d'oxyde radicalaire 12, formée par oxydation radicalaire, sert alors de passivation de la face avant 11 du premier substrat 10.

A titre d'exemple, pour des applications en photovoltaïque et dans le cas d'un substrat de GaAs dopé de type N avec une concentration de 2 à 4 x 10¹⁸ atomes/cm⁻³ d'atomes de silicium, une oxydation radicalaire d'un substrat est exécutée selon les conditions suivantes :
- le substrat de GaAs est disposé sur un support maintenu à température ambiante et exposé à l'air environnant,
- la surface du substrat de GaAs à oxyder est illuminée par une lumière ultraviolette de longueur d'onde de 185 nm et 254 nm (équipement de référence T10X10/OES de chez UVOCS^{®}),
- le temps d'exposition de la surface du substrat de GaAs à l'illumination ultraviolette est de 3 minutes.

Les conditions opératoires susmentionnées permettent de générer une couche d'oxyde radicalaire sur la surface du substrat de GaAs de 1,9 nm.

Pour des conditions opératoires équivalentes, une couche d'oxyde radicalaire de 1,8 nm est formée sur la surface d'un substrat d'InP (le substrat étant éventuellement dopé avec des atomes de soufre à une concentration de 3 à 6 x 10¹⁸ atomes par cm³).

Avantageusement, l'épaisseur de la couche d'oxyde radicalaire 12, formée à l'étape c) d'oxydation radicalaire, est inférieure à 5 nm, préférentiellement inférieure à 3 nm, encore plus préférentiellement inférieure à 2 nm.

Une étape de désoxydation de la face avant 11 peut être exécutée avant l'étape c) d'oxydation radicalaire de ladite face 11.

On peut alors disposer d'un temps de plusieurs minutes à plusieurs dizaines de minutes entre la mise en oeuvre de la désoxydation et la mise en oeuvre de l'oxydation radicalaire. Après la mise en oeuvre de la désoxydation et avant l'étape c) d'oxydation radicalaire, la présence d'un oxyde natif d'une épaisseur faible (par exemple de l'ordre de l'épaisseur de l'oxyde radicalaire à former, ou mieux d'une épaisseur de moins d'un cinquième et plus avantageusement moins d'un dixième de l'épaisseur de la couche l'oxyde radicalaire 12) ne sera pas gênante, dans la mesure où cet oxyde natif sera alors transformé pendant le temps d'oxydation radicalaire.

L'étape de désoxydation peut être exécutée par exemple par plasma (en particulier avec un gaz réducteur), par bombardement par un faisceau d'ions argon, et/ou par action d'une solution chimique de désoxydation. Par exemple, la solution chimique de désoxydation peut comprendre au moins un des éléments parmi : HF, HCl, H₂SO₄, NH₄OH, (NH₄)₂S suivant le type de matériaux III-V et selon la connaissance de l'homme de l'art.

Contrairement à l'état de la technique, la partie superficielle du premier substrat 10 endommagée (amorphisée) par une désoxydation par bombardement ionique ne pose pas de problème ; en effet cette dernière sera transformée au moins partiellement lors de la formation de la couche d'oxyde radicalaire 12.

L'étape c) est suivie d'une étape d) de collage direct de la couche d'oxyde radicalaire 12 et du second substrat 20.

La couche d'oxyde radicalaire 12 étant stable dans le temps, un délai d'attente de plusieurs heures (par exemple entre 1 et 4 heures) peut être observé entre l'étape c) et l'étape d), sans que l'efficacité de la passivation de la face avant 11 par la couche d'oxyde radicalaire 12 ne soit dégradée. Cela est conforté en particulier par une stabilité de l'épaisseur de la couche d'oxyde radicalaire 12 mesurée par ellipsométrie par exemple.

L'étape d) comprend une étape de collage direct de la couche d'oxyde radicalaire 12 avec une face du second substrat 20. Lors de l'étape de collage direct, la couche d'oxyde radicalaire 12 et ladite face du second substrat 20 sont mises en contact, plus particulièrement en contact intime, de sorte qu'elles puissent adhérer l'une sur l'autre.

A l'issue de l'étape d) de collage direct, un assemblage 30 est formé. Ledit assemblage 30 comprend, alors une couche d'oxyde radicalaire 12 disposée entre le premier 10 et le second 20 substrat.

La passivation par une couche d'oxyde radicalaire 12 présentant une meilleure stabilité dans le temps que les passivations connues de l'état de la technique, il est possible d'observer un délai de plusieurs heures (par exemple 4 heures) entre la formation de la couche d'oxyde radicalaire 12 et l'étape de collage. Tout au long de ce délai, les effets de passivation de la couche d'oxyde radicalaire 12 sont conservés. La contrainte de temps observée dans l'état de la technique est ainsi relâchée.

L'étape d) de collage direct peut être exécutée à la pression atmosphérique. Lors de la mise en contact de la couche d'oxyde radicalaire 12 et du second substrat 20, une onde de collage peut être initiée à l'aide d'une pression mécanique exercée en un point d'un des deux substrats 10 et 20 à assembler.

Selon un mode de réalisation avantageux, l'étape d) de collage direct est exécutée sous une atmosphère à humidité contrôlée, à savoir une atmosphère présentant un faible taux d'humidité.

Selon une première alternative, l'étape d) de collage direct sous une atmosphère à humidité contrôlée peut également être exécutée sous une atmosphère présentant une pression partielle en eau inférieure à 10⁻¹ Pa.

Pour ce faire, l'étape d) de collage direct sous une atmosphère à humidité contrôlée est exécutée dans une enceinte fermée, dans laquelle le taux d'humidité est contrôlé. Par exemple le taux d'humidité peut être contrôlé par la mise en oeuvre d'un tamis moléculaire permettant d'assurer une température de point de rosée d'environ -90°C et une teneur en eau inférieure à 1ppm dans une enceinte à pression atmosphérique (ce qui correspond à une pression partielle en eau inférieure à 10⁻¹ Pa pour une pression totale égale à la pression atmosphérique).

Selon une seconde alternative, l'étape d) de collage direct sous une atmosphère à humidité contrôlée peut être exécutée sous un vide partiel, le vide partiel présentant une pression inférieure à 10 Pa préférentiellement inférieure à 1 Pa, encore plus préférentiellement inférieure à 10⁻¹ Pa.

Lorsque la couche d'oxyde radicalaire 12 et le second substrat 20 sont mis en contact, et que le vide partiel atteint une pression inférieure à 10 Pa, préférentiellement inférieure à 1 Pa, et encore plus préférentiellement inférieure à 10⁻¹ Pa, une onde de collage s'initie et se propage de manière spontanée de sorte que la couche d'oxyde radicalaire 12 et le second substrat 20 se lient par adhésion directe (dite aussi moléculaire).

Les première et seconde alternatives précitées présentent l'intérêt de réduire la quantité d'eau présente à l'interface de collage pendant l'étape d). Nous parlons alors d'une étape de collage direct exécutée sous une atmosphère à humidité contrôlée. Ainsi peu ou pas de produits de réactions seront observés à l'interface d'assemblage, prévenant alors la dégradation des propriétés électriques, thermiques et optiques des assemblages 30 ainsi formés.

L'étape d) est alors suivie d'une étape e) de traitement thermique destinée à renforcer l'interface de collage, et à faire disparaître, au moins partiellement la couche d'oxyde radicalaire 12.

L'étape e) de traitement thermique peut être exécutée à une température inférieure à 600°C, de préférence comprise entre 200°C et 550°C, et mieux entre 200°C et 500°C sous une atmosphère non oxydante, par exemple de l'argon.

L'étape e) de traitement thermique dure suivant le température choisie entre quelques minutes et quelques heures, par exemple entre 10 minutes et 3 heures, pour une épaisseur de couche d'oxyde radicalaire 12 comprise entre 0,2 nm et 5 nm.

Les conditions d'exécution de l'étape e) de traitement thermique, à savoir la durée et la température à appliquer, dépendent de l'épaisseur d'oxyde radicalaire 12 à résorber et de l'épaisseur d'oxyde radicalaire acceptable à l'interface de collage en fin de traitement thermique (par exemple défini par un critère de conduction électrique et thermique ou par un critère d'absorption optique, critères imposés par l'application). Les conditions de l'exécution de l'étape e) dépendent également du renforcement attendu pour le collage.

Ainsi, la Demanderesse a constaté que la couche d'oxyde radicalaire 12 formée par oxydation radicalaire, et présente à l'interface d'assemblage à l'issue de l'étape d), disparait, au moins partiellement, sous l'effet d'un traitement thermique exécuté à une température inférieure à 600 °C. Ainsi, le procédé selon l'invention permet d'assembler des substrats présentant des coefficients de dilatation thermique différents sans pour autant dégrader l'interface d'assemblage lors de l'étape e) de traitement thermique.

Par ailleurs, la présence de la couche d'oxyde radicalaire 12 limite la réaction de la surface semi-conductrice de type III-V du premier (voire second) substrat avec l'eau présente à l'interface d'assemblage. L'interface d'assemblage est alors mieux maîtrisée.

En outre, la Demanderesse a, également, pu constater qu'une attente de 4 heures entre les étapes c), d'oxydation radicalaire, et d), de collage direct, n'altère pas la qualité de l'interface de collage.

Le problème de la multiplicité des types d'oxydes natifs susceptibles d'être présents sur la face avant d'un substrat semi-conducteur de type III-V est ainsi résolue. En effet, la présence d'une couche d'oxyde radicalaire, formée par oxydation radicalaire, limite la reformation d'oxydes natifs non contrôlés.

De plus, toute dégradation de la face avant, telle qu'une amorphisation, est améliorée, amoindrie voire supprimée par l'étape d'oxydation radicalaire qui consomme, au moins en partie, la partie superficielle dégradée du substrat.

Enfin, la quantité d'eau présente à l'interface d'assemblage, lors de l'étape d) réalisée sous une atmosphère à humidité contrôlée, est réduite.

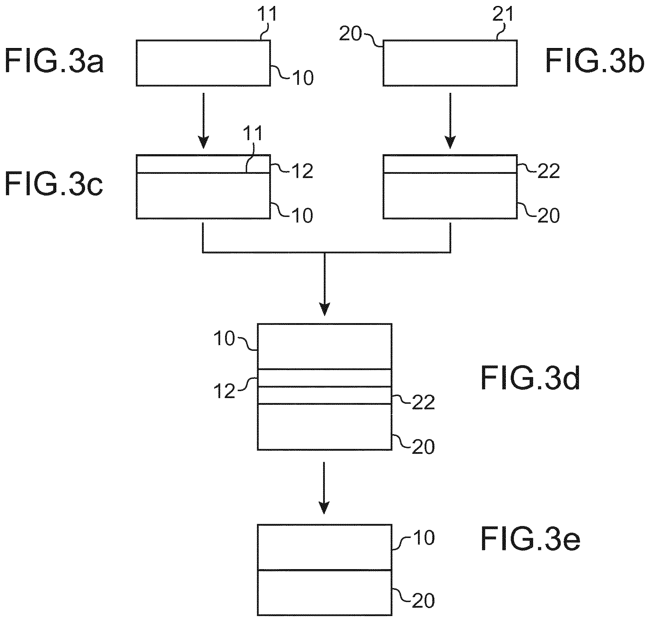

L'invention comprend également un second mode de réalisation, présenté aux figures 3a - 3e, dans lequel le second substrat 20 comprend une seconde face avant 21 faite d'un semi-conducteur de type III-V.

Le second mode de réalisation diffère du premier mode de réalisation en ce qu'il comprend une étape c1) qui consiste à former une seconde couche d'oxyde radicalaire 22 par oxydation radicalaire de la seconde face avant 21.

L'étape c1) est exécutée avant l'étape d) de collage direct.

Une étape de désoxydation de la seconde face avant 21 peut être exécutée avant l'étape c1).

L'étape de désoxydation peut être exécutée par exemple par plasma (en particulier avec un gaz réducteur), par bombardement par un faisceau d'ions argon, et/ou par action d'une solution chimique de désoxydation. Par exemple, la solution chimique de désoxydation peut comprendre au moins un des éléments parmi : HF, HCl;, H₂SO₄, NH₄OH, (NH₄)₂S suivant le type de matériaux III-V et selon la connaissance de l'homme de l'art.

Contrairement à l'état de la technique, la partie superficielle du second substrat 20 endommagée (amorphisée) par une désoxydation plasma ne pose pas de problème. En effet cette partie endommagée sera améliorée, amoindrie voire supprimée lors de la formation de la seconde couche d'oxyde radicalaire 22.

L'oxydation radicalaire est réalisée selon les même modalités que l'étape c) d'oxydation radicalaire précédemment décrite dans la description du premier mode de réalisation.

Le second substrat 20 peut être monobloc.

La seconde couche d'oxyde radicalaire 22 est en contact avec la couche d'oxyde radicalaire 12 après d'étape d) de collage direct.

Le second substrat 20 peut comprendre au moins un des éléments choisis parmi : InP, GaAs, In₁₋ₓAsₓP, InP_{1-y}Ga_{y}, In₁₋ₓAsₓP_{1-y}Ga_{y}, des alliages de matériaux des colonnes III et V.

L'épaisseur de la seconde couche d'oxyde radicalaire 22 est inférieure à 5 nm, préférentiellement inférieure à 3 nm, encore plus préférentiellement inférieure à 2 nm.

Ainsi, à titre d'illustration du second mode de réalisation, le procédé selon l'invention comprend les étapes successives suivantes :
- fournir un premier substrat 10 d'InP (de type N, dopé par du soufre à une concentration de 2,6 à 5,7 10¹⁸cm⁻³) et un second substrat 20 de GaAs (de type N, dopé par du silicium à une concentration de 2 à 3,7 10¹⁸cm⁻³),
- retirer l'oxyde natif des premier 10 et second 20 substrats avec une solution comprenant de l'acide sulfurique H₂SO₄,
- former une couche d'oxyde radicalaire 12 sur le premier substrat 10 et une seconde couche d'oxyde radicalaire 22 sur le second substrat 20 par une étape d'oxydation radicalaire ; l'oxydation radicalaire est exécutée à température ambiante, avec une illumination UV des surfaces à oxyder aux longueurs d'ondes de 185 nm et 254nm, sous air ambiant,
- assembler la couche d'oxyde radicalaire 12 et la seconde couche d'oxyde radicalaire 22 sous une atmosphère à humidité contrôlée, à savoir comprenant une pression partielle en eau inférieure à 10⁻¹ Pa,
- exécuter un traitement thermique de l'assemblage ainsi formé à une température de 500°C et d'une durée de 1 heure.

### Selon un premier exemple de cette illustration du second mode de réalisation :

Pour un temps d'oxydation radicalaire de 3 minutes, une couche d'oxyde radicalaire 12 d'une épaisseur de 1,8 nm est formée sur le premier substrat 10, et une seconde couche d'oxyde radicalaire 22 de 1,9 nm est formée sur le second substrat 20.

La résistance électrique spécifique d'interface d'un assemblage ainsi constitué est de 4,5 mΩ.cm² pour une étape d'oxydation radicalaire.

### Selon un second exemple de cette illustration du second mode de réalisation :

Pour un temps d'oxydation radicalaire de 15 minutes, une couche d'oxyde radicalaire 12 d'une épaisseur de 2,1 nm est formée sur le premier substrat 10, et une seconde couche d'oxyde radicalaire 22 de 3,8 nm est formée sur le second substrat 20.

La résistance électrique d'interface d'un assemblage ainsi constitué est de 9,5 mΩ.cm² pour une étape d'oxydation radicalaire.

Selon ce second mode de réalisation, ce sont la couche d'oxyde radicalaire 12 et la seconde couche d'oxyde radicalaire 22 qui disparaissent, au moins partiellement, lors de l'étape e) de traitement thermique.

Le procédé ainsi décrit permet d'obtenir des interfaces de collage présentant une faible résistance électrique d'interface adaptée, par exemple, pour la réalisation de cellules solaires.

Par ailleurs, la Demanderesse a également pu observer une meilleure stabilité dans le temps d'une couche d'oxyde radicalaire formée par oxydation radicalaire.

En outre, la Demanderesse a constaté, lors d'une étape e) de traitement thermique, la disparition, au moins partielle, des couches d'oxydes formées par oxydation radicalaire. Ainsi, malgré la présence d'une couche d'oxyde radicalaire à l'interface d'assemblage, il est possible de rendre l'interface d'assemblage électriquement conductrice par un simple recuit thermique exécuté à une température modérée (inférieure à 600°C).

Aussi, les dommages, créés par une éventuelle désoxydation des surfaces exécutée par un bombardement ionique, peuvent être corrigés partiellement voire totalement par le procédé selon l'invention. Peu de dommages sont alors présents dans les matériaux semi-conducteurs autour de l'interface d'assemblage. En effet, en plus de passiver la ou les surfaces à coller, une couche d'oxyde radicalaire formée par une oxydation radicalaire consomme également la partie du substrat susceptible d'avoir été endommagée, par exemple lors d'une étape de désoxydation par bombardement ionique.

Le procédé selon l'invention permet également de se prémunir des effets occasionnés par la présence d'oxydes natifs qui n'auraient pas été transformés par l'oxydation radicalaire.

Le procédé de fabrication est avantageusement mis à profit dans la fabrication de cellules solaires à base de semi-conducteurs de type III-V.

En effet, la fabrication de tels dispositifs implique le collage de jonctions faites de semi-conducteurs de type III-V, et pour lesquels les interfaces de collage doivent présenter une résistivité électrique d'interface la plus faible possible.

### RÉFÉRENCES

[1] Keisuke Nakayama, Katsuaki Tanabe, and Harry A. Atwater, "Improved electrical properties of wafer-bonded p-GaAs/n-InP interfaces with sulfide passivation" Journal of Applied Physics, 2008, vol. 103, 094503 (2008).
[2] Shiro Uchida et al., "Room-temperature GaAs/InP wafer bonding with extremely low rsiestance", Appl. Phys. Express, 2014, vol. 7, pages 112301-1 - 112301-4.
[3] Paul H. Holloway et al., Handbook of Compound Semiconductors, "Growth, Processing, Characterization, and Devices", Cambridge University Press, 19 oct. 2008, chapter 7.

## Revendications

1. Procédé de fabrication comprenant les étapes suivantes :
a) fournir un premier substrat (10) comprenant une première face dite face avant (11), ladite face avant étant faite d'un semi-conducteur de type III-V,
b) fournir un second substrat (20),
c) former une couche d'oxyde radicalaire (12) sur ladite face avant (11), du premier substrat (10) par exécution d'une oxydation radicalaire,
d) assembler, par une étape de collage direct, le premier substrat (10) et le second substrat (20) de manière à former un assemblage (30) comprenant la couche d'oxyde radicalaire (12) intercalée entre les premier (10) et second (20) substrats,
e) exécuter un traitement thermique destinée à renforcer l'interface de l'assemblage (30) formée à l'étape d), et à faire disparaître, au moins partiellement, la couche d'oxyde radicalaire (12).

2. Procédé de fabrication selon la revendication 1, dans lequel l'étape c) d'oxydation radicalaire est exécutée à pression atmosphérique.

3. Procédé de fabrication selon la revendication 1 ou 2, dans lequel la face avant (11) est désoxydée avant l'exécution de l'étape c).

4. Procédé de fabrication selon l'une des revendications 1 à3, dans lequel l'étape d), de collage direct, est exécutée sous une atmosphère à humidité contrôlée selon une des conditions suivantes :
- sous une atmosphère présentant une pression partielle en eau inférieure à 10⁻¹ Pa,
Ou
- sous un vide partiel, le vide partiel présentant une pression inférieure à 10 Pa, préférentiellement inférieure à 1 Pa, encore plus préférentiellement inférieure à 10⁻¹ Pa.

5. Procédé de fabrication selon l'une des revendications 1 à 4, dans lequel l'épaisseur de la couche d'oxyde radicalaire (12), formée à l'étape c), est inférieure à 5 nm, préférentiellement inférieure à 3 nm, encore plus préférentiellement inférieure à 2 nm.

6. Procédé de fabrication selon l'une des revendications 1 à 5, dans lequel l'oxydation radicalaire, est exécutée sous une atmosphère d'ozone et/ou d'oxygène illuminée par un rayonnement ultraviolet.

7. Procédé de fabrication selon l'une des revendications 1 à 6, dans lequel le second substrat (20) comprend au moins un des éléments choisis parmi :
silicium, germanium, alliage de silicium/germanium, saphir, alumine, verre, quartz, SiC.

8. Procédé de fabrication selon l'une des revendications 1 à 6, dans lequel le second substrat (20) est un substrat comprenant une seconde face, dite seconde face avant (21), ladite face étant faite d'un semi-conducteur de type III-V, le procédé comprend également une étape c1), de formation d'une seconde couche d'oxyde radicalaire (22) par oxydation radicalaire, sur la seconde face avant (21), la seconde couche d'oxyde radicalaire (22) étant en contact avec la couche d'oxyde radicalaire (12) après d'étape d) de collage direct.

9. Procédé de fabrication selon la revendication 8, dans lequel la seconde face avant (22) est désoxydée avant l'exécution de l'étape c1).

10. Procédé de fabrication selon la revendication 8 ou 9, dans lequel le second substrat (20) comprend au moins un des éléments choisis parmi :
InP, GaAs, In₁₋ₓAsₓP, InP₁₋yGa_{y}, In₁₋ₓAsₓP_{1-y}Ga_{y}, des alliages de matériaux des colonnes III et V.

11. Procédé de fabrication selon l'une des revendications 8 à 10, dans lequel l'épaisseur de la seconde couche d'oxyde radicalaire (22) est inférieure à 5 nm, préférentiellement inférieure à 3 nm, encore plus préférentiellement inférieure à 2 nm.

12. Procédé de fabrication selon l'une des revendications 1 à 11, dans lequel le premier substrat (10) comprend au moins un des éléments choisis parmi :
InP, GaAs, In₁₋ₓAsₓP, InP₁₋yGa_{y}, In₁₋ₓAsₓP_{1-y}Ga_{y}, des alliages de matériaux des colonnes III et V.
